(19) Europäisches Patentamt
European Patent Office
Office européen des brevets

(11) **EP 1 363 372 B1**

(12) **FASCICULE DE BREVET EUROPEEN**

(45) Date de publication et mention
de la délivrance du brevet:
**06.06.2007 Bulletin 2007/23**

(51) Int Cl.:
*H01S 5/34* (2006.01)     *H04L 9/08* (2006.01)

(21) Numéro de dépôt: **03291031.7**

(22) Date de dépôt: **28.04.2003**

(54) **Procédé d'émission d'un photon unique, dispositif semiconducteur et procédé de fabrication correspondants**

Einzelphotonemissionsverfahren, Halbleitervorrichtung und dessen Herstellungsverfahren

Single photon emission process, semiconductor device and fabrication process thereof

(84) Etats contractants désignés:
**DE FR GB IT**

(30) Priorité: **03.05.2002 FR 0205539**

(43) Date de publication de la demande:
**19.11.2003 Bulletin 2003/47**

(73) Titulaire: **STMicroelectronics S.A.**
**92120 Montrouge (FR)**

(72) Inventeurs:
• **Monfray, Stéphane**
**38000 Grenoble (FR)**
• **Dutartre, Didier**
**38240 Meylan (FR)**
• **Boeuf, Frédéric**
**38420 Le Versoud (FR)**

(74) Mandataire: **Zapalowicz, Francis**
**Bureau Casalonga & Josse**
**Bayerstrasse 71/73**
**80335 München (DE)**

(56) Documents cités:
**WO-A-01/93384**

• **BOEUF F ET AL: "16 nm planar NMOSFET manufacturable within state-of-the-art CMOS process thanks to specific design and optimisation" INTERNATIONAL ELECTRON DEVICES MEETING. TECHNICAL DIGEST (CAT. NO.01CH37224), INTERNATIONAL ELECTRON DEVICES MEETING. TECHNICAL DIGEST, WASHINGTON, DC, USA, 2-5 DEC. 2001, pages 29.5.1-4, XP002237153 2001, Piscataway, NJ, USA, IEEE, USA ISBN: 0-7803-7050-3**
• **MOREAU E ET AL: "Single-mode solid-state single photon source based on isolated quantum dots in pillar microcavities" APPLIED PHYSICS LETTERS, 29 OCT. 2001, AIP, USA, vol. 79, no. 18, pages 2865-2867, XP002237154 ISSN: 0003-6951**

EP 1 363 372 B1

## Description

L'invention concerne les circuits intégrés, et plus particulièrement les sources à photon unique.

L'invention s'applique avantageusement mais non limitativement au domaine des communications cryptographiées.

Le problème actuel des communications cryptographiées réside dans le fait que le message transmis d'un point A à un point B peut être copié dans l'intervalle qui sépare les deux points.

Afin de remédier à ce problème, il a été proposé l'utilisation de sources n'émettant qu'un seul photon à la fois pour la transmission de messages binaires, du type clé aléatoire.

Un tel exemple d'utilisation est décrit dans l'article de J. Rarity et autres, intitulé « Single Photon Sources and Applications », In Confined Photon System Fundamental and Applications, Springer Verlag LNP 351, pages 352-365.

Le problème reste cependant la fabrication d'une telle source n'émettant qu'un seul photon à la fois.

Actuellement, deux techniques majeures existent. La première est basée sur l'atténuation extrême d'une source laser. La deuxième est basée sur l'utilisation d'un filtre spectral du type microcavité sur des émetteurs de type « boîte quantique ».

La première solution présente l'inconvénient que la probabilité d'émission de deux photons au lieu d'un n'est pas négligeable, rendant par conséquent la copie de ces photons possible puisque les deux photons auront la même polarisation.

La seconde solution, décrite par exemple dans l'article de E.Moreau et autres, intitulé « Single-mode solid-state single photon source based on isolated quantun dots in pillar microcavities », Applied Physics Letters, Vol. 79, N° 18, pages 2865-2867, requiert l'utilisation de matériaux à « gap » directs (gap = différence entre la bande de conduction et la bande de valence) de type II-VI ou III-V, qui sont des matériaux extrêmement délicats à travailler.

L'invention vise à apporter une solution à ce problème concernant les sources à photon unique, quelles que soient leurs applications.

Un but de l'invention est de proposer une solution radicalement différente de celle de l'art antérieur et basée sur une fabrication « tout silicium », ou plus précisément « tout matériau compatible silicium ».

Plus précisément, selon l'invention, un transistor MOS sert de source à électron unique. Cet électron est ensuite collecté par une boîte quantique qui va émettre un photon unique lors de la recombinaison de cet électron unique.

Et, l'invention est remarquable en ce sens que la délivrance de cet électron unique s'effectue de façon contrôlée par application d'une tension de commande appliquée sur la grille du transistor.

La délivrance d'un électron unique est basée, soit sur un phénomène de blocage de Coulomb, soit sur un phénomène d'effet tunnel résonant.

Un effet de blocage de Coulomb, se traduisant par des oscillations dans le canal d'un transistor MOS, a déjà été décrit dans l'article de Frédéric Boeuf et autres, intitulé « 16 nm planar NMOSFET manufacturable within state-of-the-art CMOS process thanks to specific design and optimisation », proceedings IEDM 2001, pp. 637. Cependant, le phénomène d'oscillation résultait du désordre électrostatique de la structure et n'était donc pas contrôlé, et par conséquent ne pouvait pas être industriellement utilisé de façon reproductible.

L'invention propose donc un circuit intégré, comprenant un dispositif semiconducteur formant source à photon unique, comportant sur un substrat en silicium un transistor MOS ayant une grille en forme de champignon, ou en forme de T, capable de délivrer sur son drain, de façon contrôlée, un électron unique en réponse à une tension de commande appliquée sur sa grille.

Par ailleurs, le dispositif semiconducteur formant source à photon unique comporte au moins une boîte quantique compatible silicium, électriquement couplée à la région de drain du transistor, et capable d'émettre un photon unique à la réception d'un électron unique émis par le transistor.

Au sens de la présente invention, une boîte quantique « compatible silicium » est une boîte formée de matériaux compatibles avec du silicium, par exemple du silicium et un alliage de silicium-germanium.

La grille en forme de champignon du transistor peut être réalisée par un pied de grille ayant une longueur L et une largeur W, surmonté d'un chapeau. Des régions isolantes latérales (espaceurs) s'appuient sur les flancs de la grille, et les régions de source et de drain du transistor sont situées dans le substrat à distance des bords latéraux du pied de grille.

Ainsi, en raison d'une telle architecture, une large concentration de porteurs est créée au milieu du canal, comparativement aux régions du canal qui ne sont pas surmontées par le pied de grille.

Ainsi, l'application de la tension de commande sur la grille du transistor provoque un potentiel dans le canal présentant une forme de « dos de chameau », ce qui permet de confiner les porteurs dans un puits quantique. Et, cette forme en dos de chameau permet d'obtenir de façon contrôlée l'effet de blocage de Coulomb ou l'effet tunnel résonant.

La température de fonctionnement du dispositif, ainsi que son dimensionnement et les tensions appliquées, sont autant de paramètres sur lesquels il est possible d'agir pour assurer le principe de blocage de Coulomb ou d'effet tunnel résonant. L'homme du métier saura ajuster ces paramètres en fonction de l'application envisagée.

Ceci étant, si l'on souhaite travailler à des tensions de grille compatibles avec les tensions habituellement utilisées dans les dispositifs CMOS, il est préférable que la largeur W du pied de grille soit inférieure à quelques centaines de nanomètres, par exemple inférieure à 500 nm. En effet, au-delà, il sera possible d'observer un phénomène de blocage de Coulomb, mais celui-ci sera dû au désordre électrostatique de la structure. Et, il ne sera donc pas possible de contrôler la tension de fonctionnement du dispositif.

Par ailleurs, selon un mode de réalisation de l'invention, les valeurs de L et de W sont choisies de sorte que l'énergie thermique des électrons dans la source du transistor soit inférieure à l'énergie électrostatique d'un électron pénétrant dans le canal du transistor. Ceci est une façon d'assurer le principe de blocage de Coulomb.

Ainsi, par exemple, la température de fonctionnement du dispositif est avantageusement choisie inférieure à 77°K, et L est choisi de préférence inférieur à 50 nm.

Par ailleurs, il est particulièrement avantageux, dans les applications envisagées, que la tension appliquée sur le drain du transistor soit inférieure à 10 mV. En effet, la tension de drain doit être suffisamment faible pour que la tension de grille puisse permettre la création d'une structure double barrière (forme en dos de chameau), permettant le blocage de Coulomb ou l'effet tunnel résonant.

Selon un mode de réalisation de l'invention, le circuit intégré comporte des moyens de commande aptes à délivrer ladite tension de commande, cette tension de commande ayant une première valeur en réponse à laquelle le transistor est bloqué, cette première valeur étant au moins nulle, ce qui permet d'assurer une nullité du courant dans l'état bloqué, et une deuxième valeur permettant la création d'un puits quantique dans le canal du transistor et le passage d'un électron unique de la source vers le canal, puis vers le drain.

Lorsque L est supérieur ou égal à 10 nm et inférieur à 50 nm, la délivrance de l'électron unique est basée sur le phénomène de blocage de Coulomb. Dans ce cas, le produit de la deuxième valeur de la tension de commande par la charge d'un électron est un multiple entier de l'énergie électrostatique d'un électron pénétrant dans le canal du transistor. On choisira de préférence une deuxième valeur, tel que le produit de cette deuxième valeur par la charge d'un électron soit égal à l'énergie électrostatique d'un électron pénétrant dans le canal du transistor.

Lorsque L est inférieur à 10 nm, le blocage de Coulomb peut être remplacé par un effet tunnel résonant. Dans ce cas, la deuxième valeur de la tension de commande correspond à un alignement du niveau fondamental d'énergie du dispositif avec le niveau de Fermi de la source du transistor.

Afin de pouvoir émettre des électrons uniques successifs, les moyens de commande sont avantageusement aptes à délivrer successivement les deux valeurs de la tension de commande à une fréquence de travail qui est supérieure à la fréquence de sortie d'un électron du canal. En effet, ceci permet d'assurer qu'un seul électron ne sorte à la fois.

A titre indicatif, une telle fréquence de travail peut être comprise entre 1 MHz et 1 GHz.

Le dispositif selon l'invention comporte avantageusement plusieurs boîtes quantiques adjacentes, qui peuvent être disposées dans un même plan horizontal et/ou dans des plans horizontaux adjacents empilés.

On augmente ainsi la probabilité d'émission d'un photon unique par recombinaison de l'électron unique dans l'une des boîtes quantiques.

Afin d'assurer un meilleur couplage électrique entre la région de drain du transistor et les boîtes quantiques, il est préférable que le substrat comprenne une région implantée supplémentaire, située sous chaque boîte quantique, de même type de conductivité que celui de la région de drain, et en contact avec la région de drain.

Chaque boîte quantique peut comporter par exemple du germanium encapsulé dans du silicium.

Le circuit intégré comporte également, selon un mode de réalisation de l'invention, une couche de matériau isolant enrobant le transistor, cette couche de matériau isolant comportant un orifice débouchant au-dessus des boîtes quantiques et formant un guide d'onde optique.

Pour certaines applications, le circuit intégré peut être disposé dans une enceinte réfrigérée.

L'invention a également pour objet un dispositif de cryptographie comportant un circuit intégré tel que défini ci-avant.

L'invention a encore pour objet un procédé d'émission d'un photon unique, comportant une application sur la grille en forme de champignon d'un transistor MOS, d'une tension de commande de façon à générer un unique électron au niveau du drain du transistor, et un piégeage de cet électron unique dans une boîte quantique, provoquant l'émission d'un photon unique.

L'invention a encore pour objet un procédé de fabrication d'un circuit intégré, comprenant un dispositif semiconducteur formant source à photon unique, dans lequel on réalise dans et sur un substrat en silicium

- un transistor MOS ayant une grille de forme de champignon, capable de délivrer sur son drain, de façon contrôlée, un électron unique en réponse à une tension de commande appliquée sur sa grille, et

- au moins une boîte quantique compatible silicium, électriquement couplée à la région de drain du transistor, et capable d'émettre un photon unique à la réception d'un électron unique émis par le transistor.

Selon un mode de mise en oeuvre de l'invention, on réalise plusieurs boîtes quantiques adjacentes et cette réalisation comporte par exemple une croissance sélective de germanium sur la surface d'une première région prédéterminée de substrat, puis une croissance sélective de silicium sur le germanium.

Selon un mode de mise en oeuvre de l'invention, la réalisation du transistor comporte la formation sur la surface d'une deuxième région prédéterminée du substrat, d'un corps de grille isolé de ladite surface par un oxyde de grille, puis une gravure latérale du corps de grille de façon à former un pied de grille surmonté d'un chapeau.

Le corps de grille est par exemple un empilement hétérogène comprenant une couche inférieure et une couche supérieure, le matériau de la couche supérieure pouvant être gravé sélectivement par rapport au matériau de la couche supérieure.

Le matériau de la couche inférieure est par exemple un alliage de silicium et de germanium, tandis que le matériau de la couche supérieure est du silicium.

Par ailleurs, les régions de source et de drain du transistor sont avantageusement implantées dans le substrat en utilisant le chapeau de grille comme masque dur.

D'autres avantages et caractéristiques de l'invention apparaîtront à l'examen de la description détaillée de modes de réalisation et de mises en oeuvre, nullement limitatifs, et des dessins annexés, sur lesquels :

- la figure 1 illustre schématiquement un mode de réalisation d'un dispositif semiconducteur formant source d'un photon unique selon l'invention ;
- la figure 2 illustre schématiquement une représentation du dispositif de la figure 1 sous une forme intégrée ;
- la figure 3 illustre schématiquement un puits quantique formé sous la grille d'un transistor d'un dispositif selon l'invention ;
- -les figures 4a à 4f illustrent schématiquement un mode de fonctionnement du dispositif selon l'invention faisant intervenir un blocage de Coulomb ;
- les figures 5a à 5e illustrent un autre mode de fonctionnement du dispositif selon l'invention faisant intervenir un effet tunnel résonant ;
- la figure 6 illustre un profil de la bande de conduction d'un dispositif selon l'invention ; et
- les figures 7a à 7i illustrent schématiquement les principales étapes d'un mode de mise en oeuvre d'un procédé de fabrication selon l'invention.

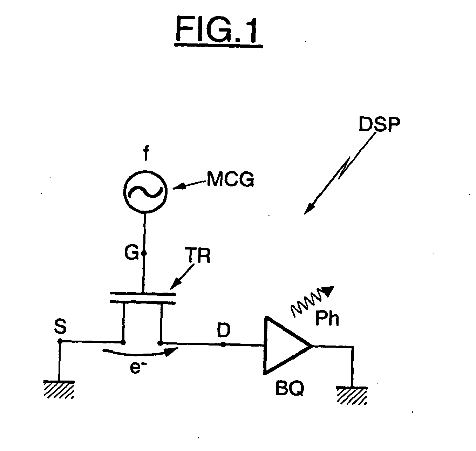

Sur la figure 1, la référence DSP désigne un dispositif semiconducteur formant source à photon unique.

Ce dispositif comporte un transistor MOS, référencé TR dont la source est reliée à la masse, et capable de délivrer sur son drain un électron unique en réponse à une tension de commande appliquée sur sa grille G et délivrée par des moyens de commande MCG.

Ces moyens de commande MCG appliquent également une tension sur le drain D.

A ce drain, est connectée une boîte quantique BQ dans laquelle l'électron unique émis par le transistor va être piégé et se recombiner en provoquant l'émission d'un photon unique ph.

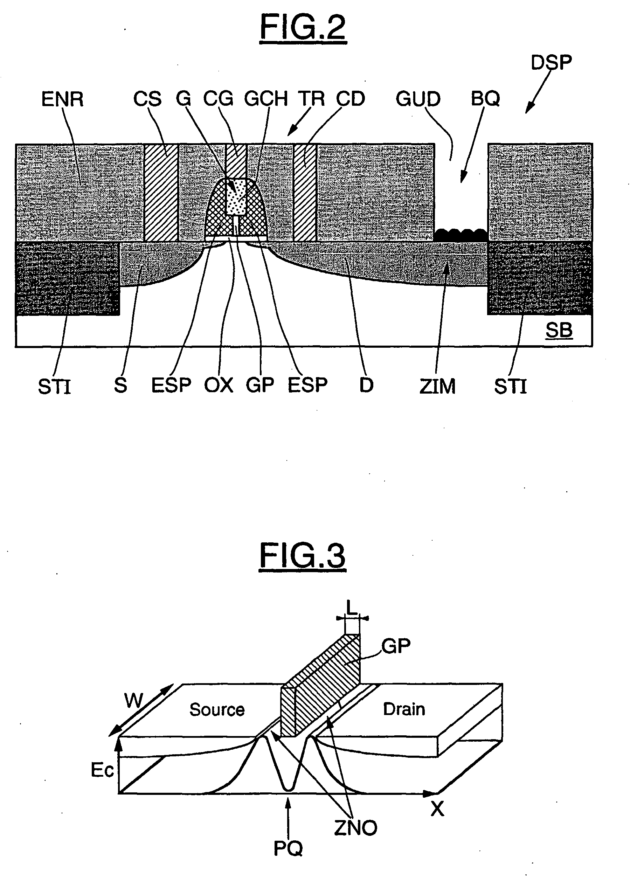

En pratique, comme illustré sur les figures 2 et 3, ce dispositif DSP est réalisé sous forme intégrée sur une puce semiconductrice dont le substrat, par exemple dopé P⁻, est référencé SB.

Le transistor TR, par exemple un transistor NMOS, a une grille G en forme de champignon, ou de T. Plus précisément, la grille G du transistor comporte un pied de grille GP ayant une longueur L (la longueur étant une distance comptée parallèlement à la direction source/drain) et une largeur W (la largeur W étant une dimension comptée perpendiculairement à la longueur).

Le pied de grille GP est surmonté d'un chapeau GCH ayant une longueur plus importante que la longueur du pied de grille.

Le transistor TR comporte par ailleurs des régions latérales isolantes (espaceurs) ESP s'appuyant sur les flancs de la grille, ainsi que des régions de source et de drain S et D qui sont implantées dans le substrat à distance des bords latéraux du pied de grille GP.

La région de canal du transistor présente donc des zones ZNO qui ne sont pas recouvertes par le pied de grille GP.

De ce fait, la structure présente dans la bande de conduction et sous l'application d'une tension de grille prédéterminée, un profil en dos de chameau (figure 3) conduisant à l'apparition d'un puits quantique PQ se situant sensiblement au milieu du canal.

La grille G du transistor TR est isolée de la surface supérieure du substrat SB par un oxyde de grille OX et est encapsulée dans un milieu isolant ENR. Le dispositif comporte également des vias métalliques CS, CG et CD, permettant des prises de contact sur les régions respectives de source, de grille et de drain.

La zone active du substrat SB, délimitée par des régions d'isolation STI, par exemple du type tranchée peu profonde, comporte plusieurs boîtes quantiques BQ disposées à la surface du substrat. Sous ces boîtes quantiques BQ, le substrat SB comporte une zone implantée ZIM, de même type de conductivité (par exemple N⁺) que la région de drain D du transistor et qui est en contact avec cette région de drain. Les boîtes quantiques BQ sont par conséquent couplées électriquement à la région de drain du transistor.

Le photon émis par l'une de ces boîtes quantiques BQ sera dirigé vers l'extérieur du dispositif par un guide d'onde optique GUD ménagé dans un orifice du milieu enrobant ENR qui débouche au-dessus de ces boîtes quantiques BQ.

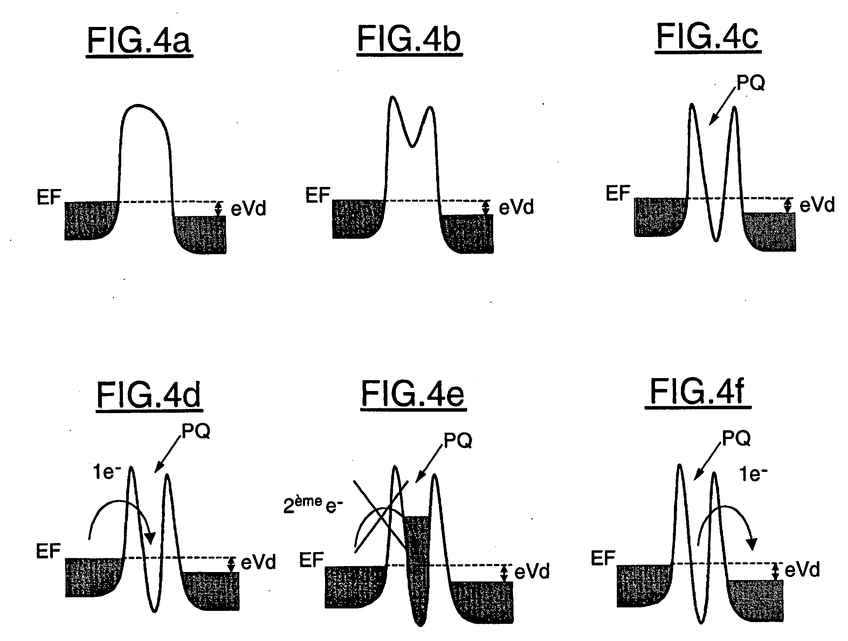

On va maintenant décrire plus en détail, en se référant plus particulièrement aux figures 4a à 4f, un mode de fonctionnement du dispositif selon l'invention, et plus particulièrement un mode de fonctionnement du transistor TR basé sur le principe de blocage de Coulomb.

Le phénomène de blocage de Coulomb, bien connu de l'homme du métier, est basé sur l'utilisation d'une capacité suffisamment petite pour pouvoir être pleine et interdire de ce fait la rentrée d'un nouvel électron.

Dans le régime de fonctionnement utilisant le principe de blocage de Coulomb, on néglige l'aspect quantique du canal, c'est-à-dire que la quantification de l'énergie est négligeable devant l'énergie électrostatique.

Afin d'assurer le principe de blocage de Coulomb, il faut que l'énergie thermique des électrons dans la source du transistor soit inférieure à l'énergie électrostatique d'un électron pénétrant dans le canal du transistor.

En première approximation, l'énergie électrostatique d'un transistor pénétrant dans le canal est définie par la formule (I) ci-dessous :

$$e^2/(2\ \varepsilon_{Si}\varepsilon_0\ d) \qquad (I)$$

dans laquelle e désigne la charge d'un électron, $\varepsilon_{Si}$ désigne la permittivité du silicium et d est le « diamètre » du dispositif qui est égal en première approximation à $(WxL)^{1/2}$.

L'énergie thermique est égale à kxT, où k désigne la constante de Boltzmann et T la température de fonctionnement du dispositif.

Ainsi, pour un fonctionnement à une température T=300°K, il faut que d soit approximativement égal à 5 nm. Pour un fonctionnement à basse température, c'est-à-dire inférieur à 77°K, il faut un diamètre d égal à 200 nm environ.

A titre indicatif, des valeurs de L et de W, respectivement égales à 30 nm et à 300 nm, conviennent pour un fonctionnement à une température égale à 4,2°K.

D'une façon générale, si W est très grand, par exemple égal à 1 $\mu$m ou 10 $\mu$m, on pourra observer un phénomène de blocage de Coulomb, mais celui-ci sera dû au désordre électrostatique de la structure. Il ne sera donc pas possible alors de contrôler la délivrance d'un électron unique. C'est la raison pour laquelle on se limitera en pratique à des valeurs de W inférieures à 500 nm.

Sur les figures 4a à 4f, on a représenté le profil de l'énergie dans le canal du transistor. $E_F$ désigne le niveau de Fermi de la source et Vd désigne la tension appliquée sur le drain du transistor.

Sur la figure 4a, la tension Vg appliquée sur la grille du transistor est nulle. Il n'y a pas de création de puits de potentiel. Et, la température de fonctionnement du dispositif est choisie de telle sorte que la valeur de l'énergie thermique des électrons soit très inférieure à la hauteur de la barrière de potentiel ainsi définie. De ce fait, il n'y a aucun passage d'électron et le transistor est bloqué.

Sur la figure 4b, la tension de grille devient positive. Le puits de potentiel commence à se créer, mais l'énergie minimale reste bien au-dessus du niveau de Fermi de la source. Aucun courant ne passe.

Lorsque la tension de grille atteint une deuxième valeur égale à Vg0, le puits quantique PQ est en dessous ou au niveau de Fermi de la source, et un électron peut rentrer dans le canal (figures 4c et 4d).

A cet égard, la tension de drain doit être suffisamment faible pour que la tension de grille puisse permettre la création de la structure double barrière permettant le blocage de Coulomb.

Typiquement, dans le cas présent, on choisira une tension de drain inférieure à 10 mV. La tension de grille minimum à appliquer pour arriver dans l'état passant du transistor est la tension de seuil de ce transistor, déterminée de manière classique par l'épaisseur de l'oxyde de grille OX, le dopage du canal et le travail de sortie du matériau servant d'électrode de grille. Le produit de cette tension de grille Vg0 par la charge e d'un électron, doit être égal à l'énergie électrostatique de cet électron pénétrant dans le canal du transistor.

Une fois que l'électron a pénétré dans le canal du transistor (figure 4e), celui-ci modifie l'énergie du canal d'une valeur égale à son énergie électrostatique. La capacité du transistor est par conséquent pleine, empêchant un deuxième électron de rentrer dans le canal.

Par ailleurs, comme illustré sur la figure 4f, l'électron ayant pénétré dans le canal passe dans le drain D par effet tunnel, provoquant la création d'un courant de drain.

Cet électron va être ensuite piégé dans l'une des boîtes quantiques BQ et provoquer l'émission d'un photon unique ph.

Chaque fois que le produit de la charge d'un électron par la valeur de la tension de grille prend une valeur multiple de l'énergie électrostatique, un électron peut rentrer dans le canal et le transistor est débloqué. En-dehors de ces valeurs, le transistor est bloqué.

Bien qu'il serait possible de travailler autour de l'une quelconque de ces valeurs multiples, il s'avère préférable de faire varier la tension de grille entre la valeur 0 et une valeur telle que le produit de cette valeur par la charge de l'électron soit égale à l'énergie électrostatique.

Les moyens de commande sont alors aptes à délivrer successivement les deux valeurs de la tension de commande à une fréquence de travail qui est supérieure à la fréquence de sortie d'un électron du canal, en pratique comprise entre 1 MHz et 1 GHz. Ceci permet d'assurer qu'un seul électron ne sorte à la fois.

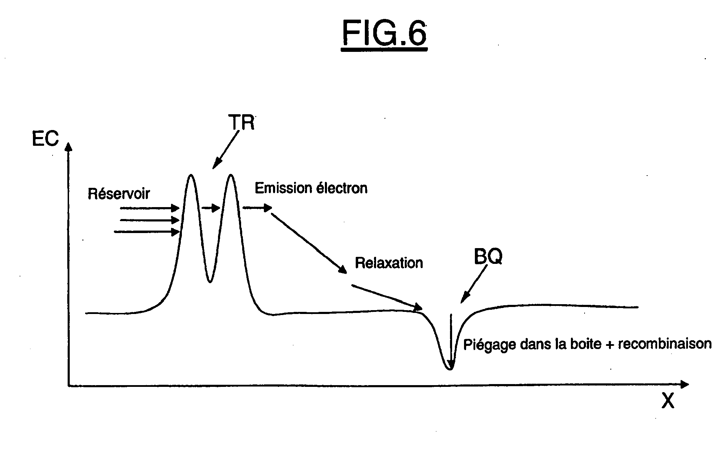

Le profil de la structure dans la bande de conduction, tel que représenté sur la figure 6, illustre le fonctionnement du dispositif selon l'invention.

Si les boîtes quantiques présentaient un rendement de conversion égal à 1, le débit de données transmises par un tel dispositif serait égal à la fréquence de travail f. Ceci étant, les rendements de conversion dans un système utilisant des matériaux à gap non directs sont en général très faibles. Mais, ceci n'est pas gênant dans les applications de cryptographie, puisque la quantité d'informations à transmettre par cryptographie quantique peut rester relativement faible. Typiquement, une clé de codage est codée sur 128 bits.

A titre d'exemple, pour une fréquence de travail de 1 MHz et un rendement de conversion égal à $10^{-7}$, le

nombre de bits transmis par seconde est égal à 0,1, ce qui nécessite alors un temps d'environ 20 minutes pour transmettre une clé de 128 bits. Ceci étant, on peut montrer qu'à l'aide de cristaux photoniques, le rendement quantique des boîtes à base de silicium peut passer à $10^{-3}$, ce qui ramènerait dans le cas présent la durée de transmission d'une clé de 128 bits à 0,1 seconde.

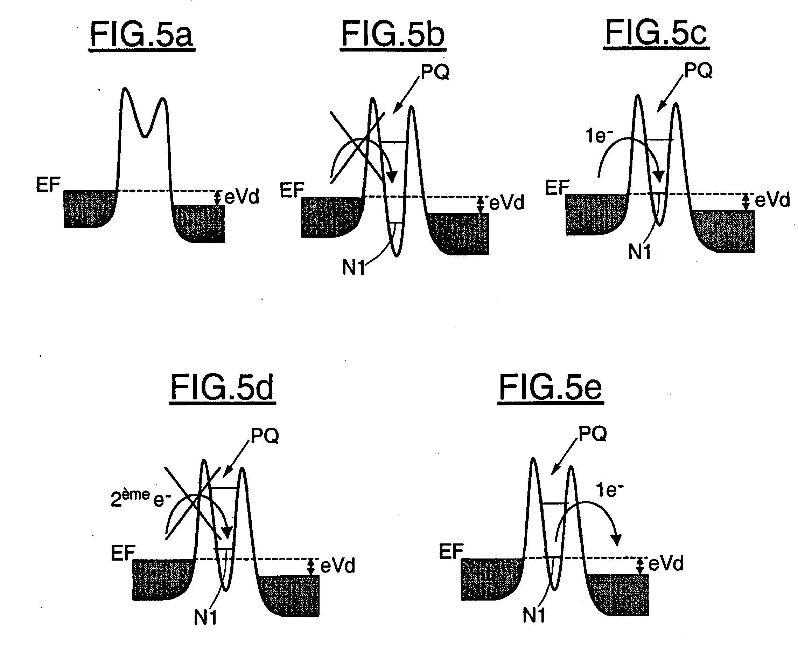

Lorsque la longueur L du pied de grille est particulièrement faible, typiquement inférieure à 10 nm, le blocage de Coulomb peut être remplacé par un effet tunnel résonant. Ceci conduit au même résultat, mais les conditions de détermination des états bloqués et passants du transistor sont différentes. Un exemple de fonctionnement à base d'effet tunnel résonant, est illustré sur les figures 5a à 5e.

Dans ce régime, l'énergie des niveaux quantifiés est supérieure à l'énergie électrostatique. La condition de passage d'un électron de la source au drain est déterminée à la fois par l'alignement du niveau fondamental N1 du puits quantique avec le niveau de Fermi EF de la source et l'énergie électrostatique apportée par l'électron dans le canal.

Plus précisément, comme illustré sur la figure 5a, l'application de la tension de commande de la grille permet la création d'un puits quantique.

Lorsque la tension de grille augmente, le puits se creuse (figure 5b) et les niveaux d'énergies quantiques apparaissent. Cependant, si le niveau fondamental N1 n'est pas aligné avec le niveau de Fermi EF de la source, l'électron ne peut pas rentrer dans le canal.

Par contre (figure 5c), si le niveau fondamental N1 est aligné avec le niveau de Fermi, l'électron entre dans le canal.

Et, l'énergie électrostatique apportée décale alors le niveau fondamental, interdisant alors à un autre électron de rentrer dans le canal (figure 5d).

L'électron qui est dans le canal peut sortir par effet tunnel, ramenant le système dans un état initial (figure 5e).

La détermination de la condition de blocage impose de connaître la valeur de l'énergie du niveau fondamental N1. Un tel calcul est bien connu de l'homme du métier et il dépend en particulier de la forme de la grille, c'est-à-dire de la longueur L du pied de grille et du non-recouvrement des zones d'extension avec la grille, ainsi que du profil de la jonction source/canal et canal/drain.

En ce qui concerne les boîtes quantiques, les articles

- de Boucaud, intitulés « Optical recombination from excited states in Ge/Si self-assembled quantum dots », Physical Review B, Volume 64, 155310, et
- de T. Brunhes, et autres, intitulés « Electroluminescence of Ge/Si self-assembled quantum dots grown by chemical vapor deposition » (Applied Physics Letters, Volume 77, N°12, 18 septembre 2000, en ont montré un exemple de réalisation.

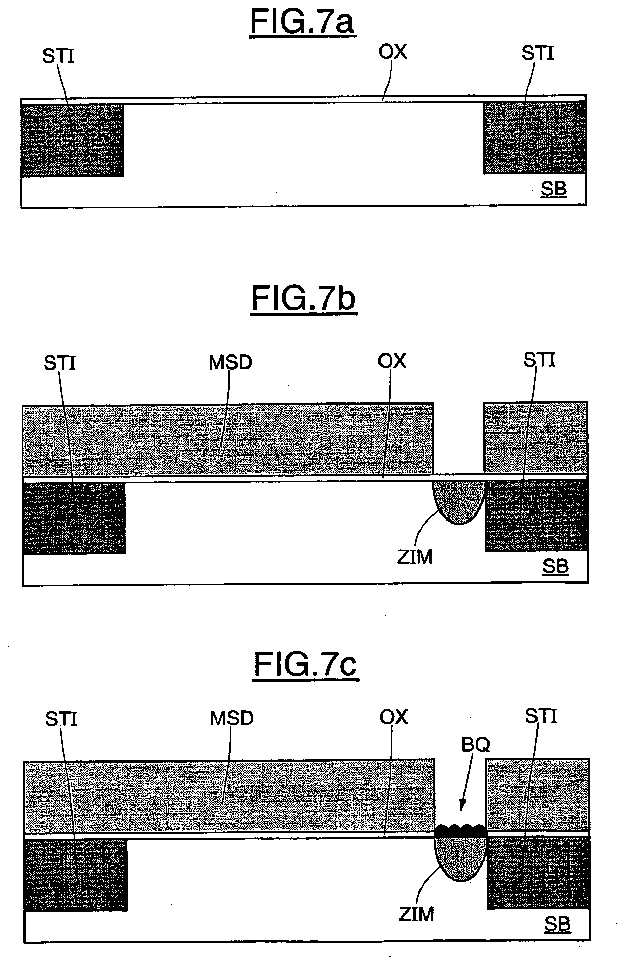

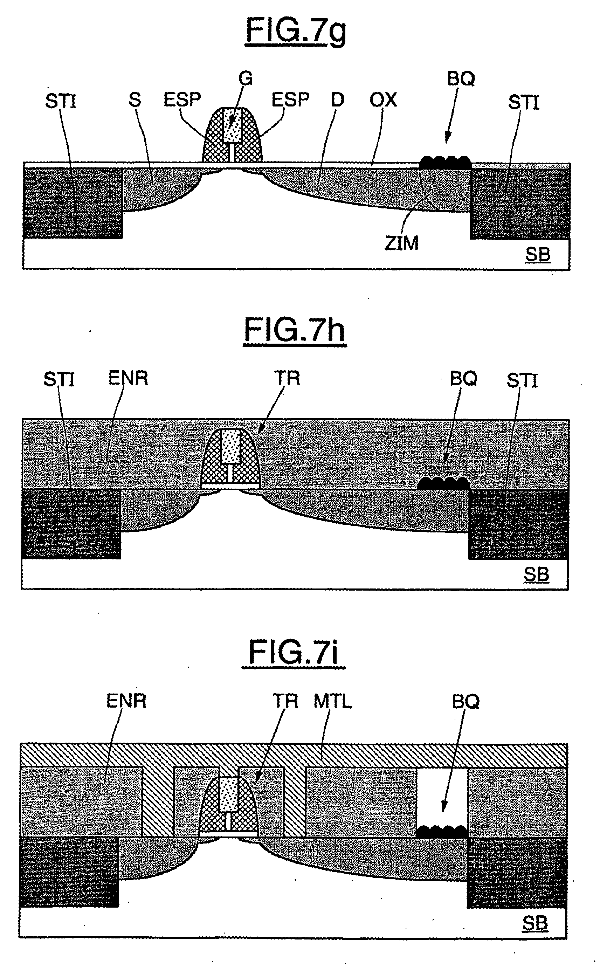

Un autre exemple de réalisation va maintenant être illustré sur les figures 7a à 7i, qui ont trait à un mode de mise en oeuvre d'un procédé de fabrication d'un dispositif selon l'invention.

Sur la figure 7a, la référence SB désigne le substrat de silicium, par exemple dopé P⁻, au sein duquel on a réalisé une zone active délimitée de façon classique et connue en soi par des régions d'isolation STI, par exemple dites « tranchées peu profondes ».

On fait croître ensuite un oxyde thermique OX sur la surface du substrat.

Puis, on définit l'emplacement des futures boîtes quantiques à l'aide d'un masque dur réalisé par exemple en une couche de nitrure de silicium. On réalise alors, à l'endroit des futures boîtes quantiques, une implantation d'une zone ZIM qui aura le même type de conductivité que la zone de drain du transistor (figure 7b).

Puis, on procède au-dessus de la zone ZIM à une désoxydation (figure 7c), puis à une croissance sélective de germanium suivie d'une croissance sélective de silicium. La croissance de germanium se traduit par la formation de gouttelettes hémisphériques dont chacune d'entre elles forme une boîte quantique BQ.

On procède ensuite (figure 7d) à une implantation puis à un retrait sélectif du masque dur.

Les étapes suivantes consistent à réaliser le transistor avec sa grille en forme de champignon.

A cet égard, l'homme du métier pourra se référer, à toutes fins utiles, à la demande de brevet français n° 2 791 177, qui décrit une telle réalisation.

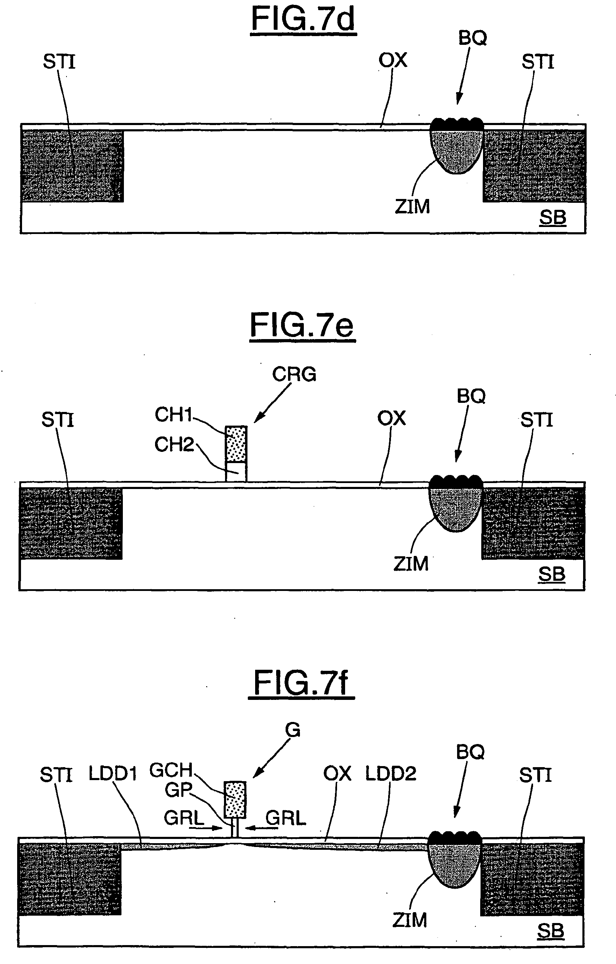

On en rappelle ici, en se référant plus particulièrement aux figures 7e à 7g, les principales étapes.

Plus précisément, la première d'elle elles consiste à déposer un empilement d'une couche inférieure formée par exemple d'un alliage polycristallin de silicium et de germanium, tel que du $Si_{0,75}Ge_{0,25}$, en une épaisseur par exemple de 500 Å.

La couche inférieure est surmontée d'une couche supérieure de polysilicium, ayant par exemple une épaisseur de 1000 Å.

On procède ensuite à une gravure classique de la grille, de façon à obtenir un corps de grille CRG, ayant une longueur L par exemple égale à 80 nm.

On procède ensuite à une gravure latérale GRL de la couche inférieure CH2 jusqu'à obtenir un pied de grille GP ayant une longueur par exemple égale à 16 nm. La couche supérieure CH2, non gravée, devient alors le chapeau de grille GCH (figure 7f). La gravure GRL peut s'effectuer en utilisant une solution chimique sélective par rapport au silicium, telle qu'une solution 40 ml $HNO_3$ à 70% - 20 ml $H_2O_2$ - 5 ml HF 0,5%. On peut également effectuer une gravure latérale par attaque plasma isotrope sélectif par rapport au silicium et à l'oxyde.

On procède ensuite à l'implantation des zones d'extension de source et de drain LDD1 et LDD2.

Puis, on réalise de façon classique et connue en soi des régions latérales isolantes (espaceurs) s'appuyant sur les flancs de la grille. Ces espaceurs ESP sont par exemple réalisés en nitrure de silicium (figure 7g).

On réalise ensuite une deuxième implantation, de façon à former les régions de source et de drain, la région de drain venant contacter la zone implantée ZIM située sous les boîtes quantiques BQ.

Puis, on dépose une couche d'un milieu isolant ENR, par exemple de l'oxyde TEOS, sur la structure obtenue à la figure 7g.

On grave ensuite des orifices dans le milieu isolant ENR que l'on vient remplir de métal MTL (figure 7i).

L'étape suivante, qui permet d'aboutir au dispositif illustré sur la figure 2, comporte notamment une étape de photolithographie de façon à définir l'emplacement de l'orifice débouchant au-dessus des boîtes quantiques, puis une gravure de la couche métallique et une ouverture de l'orifice au-dessus des boîtes quantiques. Cet orifice sert de guide d'onde. Il pourrait être également rempli de silicium.

La puce contenant le dispositif ainsi réalisé peut être alors incorporée dans une enceinte réfrigérée. L'ensemble peut alors former un dispositif de cryptographie capable d'émettre un train de photons, photon après photon.

**Revendications**

1. Circuit intégré, comprenant un dispositif semiconducteur formant source à photon unique, comportant sur un substrat en silicium (SB) un transistor MOS (TR) ayant une grille en forme de champignon, capable de délivrer sur son drain, de façon contrôlée, un électron unique en réponse à une tension de commande appliquée sur sa grille, et au moins une boîte quantique (BQ) compatible silicium, électriquement couplée à la région de drain (D) du transistor, et capable d'émettre un photon unique à la réception d'un électron unique émis par le transistor.

2. Circuit intégré selon la revendication 1, **caractérisé par le fait que** la grille (G) du transistor comporte un pied de grille (GP) ayant une longueur L et une largeur W, surmonté d'un chapeau (GCH), des régions isolantes latérales (ESP) sur les flancs de la grille, et des régions de source et de drain situées dans le substrat à distance des bords latéraux du pied de grille.

3. Circuit intégré selon la revendication 2, **caractérisé par le fait que** les valeurs de L et de W sont choisies de sorte que l'énergie thermique des électrons dans la source du transistor (TR) soit inférieure à l'énergie électrostatique d'un électron pénétrant dans le canal du transistor.

4. Circuit intégré selon la revendication 3, **caractérisé par le fait que** la température de fonctionnement du dispositif est inférieure à 77°K et **par le fait que** L est inférieur à 50 nanomètres.

5. Circuit intégré selon la revendication 3 ou 4, **caractérisé par le fait que** W est inférieur à quelques centaines de nanomètres, par exemple 500 nanomètres.

6. Circuit intégré selon l'une des revendications précédentes, **caractérisé par le fait que** la tension appliquée sur le drain (D) du transistor est inférieure à 10 mV.

7. Circuit intégré selon l'une des revendications précédentes, **caractérisé par le fait qu'**il comporte des moyens de commande (MCG) aptes à délivrer ladite tension de commande, cette tension de commande ayant une première valeur au moins nulle en réponse à laquelle le transistor est bloqué, et une deuxième valeur permettant la création d'un puits quantique dans le canal du transistor et le passage d'un électron unique de la source dans le canal puis vers le drain.

8. Circuit intégré selon les revendications 2 et 7, **caractérisé par le fait que** L est supérieur ou égal à 10 nanomètres et inférieur à 50 nanomètres, et **par le fait que** le produit de la deuxième valeur de la tension de commande par la charge (e) d'un électron est un multiple entier de l'énergie électrostatique d'un électron pénétrant dans le canal du transistor.

9. Circuit intégré selon la revendication 8, **caractérisé par le fait que** le produit de la deuxième valeur de la tension de commande par la charge (e) d'un électron est égal à l'énergie électrostatique d'un électron pénétrant dans le canal du transistor.

10. Circuit intégré selon les revendications 2 et 7, **caractérisé par le fait que** L inférieur à 10 nanomètres, et **par le fait que** la deuxième valeur de la tension de commande correspond à un alignement du niveau fondamental d'énergie du dispositif avec le niveau de Fermi de la source du transistor.

11. Circuit intégré selon l'une des revendications 7 à 10, **caractérisé par le fait que** les moyens de commande (MCG) sont aptes à délivrer successivement les deux valeurs de la tension de commande à une fréquence de travail (f) supérieure à la fréquence de sortie d'un électron du canal.

12. Circuit intégré selon la revendication 11, **caractérisé par le fait que** la fréquence de travail (f) est comprise entre 1 MHz et 1 GHz.

**13.** Circuit intégré selon l'une des revendications précédentes, **caractérisé par le fait que** le dispositif comporte plusieurs boîtes quantiques adjacentes (BQ).

**14.** Circuit intégré selon l'une des revendications précédentes, **caractérisé par le fait que** le substrat (SB) comporte une région implantée supplémentaire (ZIM), située sous chaque boîte quantique, de même type de conductivité que celui de la région de drain, et en contact avec la région de drain.

**15.** Circuit intégré selon l'une des revendications précédentes, **caractérisé par le fait que** chaque boîte quantique (BQ) comporte du germanium encapsulé dans du silicium.

**16.** Circuit intégré selon l'une des revendications précédentes, **caractérisé par le fait que** le dispositif comporte une couche de matériau isolant (ENR) enrobant le transistor, cette couche de matériau isolant comportant un orifice débouchant au dessus des boîtes quantiques et formant un guide d'ondes optique (GUD).

**17.** Circuit intégré selon l'une des revendications précédentes, **caractérisé par le fait qu'**il est disposé dans une enceinte réfrigérée.

**18.** Dispositif de cryptographie, **caractérisé par le fait qu'**il comporte un circuit intégré selon l'une des revendications 1 à 17.

**19.** Procédé de fabrication d'un circuit intégré comprenant un dispositif semiconducteur formant source à photon unique, dans lequel on réalise dans et sur un substrat en silicium (SR), un transistor MOS (TR) ayant une grille en forme de champignon, capable de délivrer sur son drain, de façon contrôlée, un électron unique en réponse à une tension de commande appliquée sur sa grille, et au moins une boîte quantique (BQ) compatible silicium, électriquement couplée à la région de drain du transistor, et capable d'émettre un photon unique à la réception d'un électron unique émis par le transistor.

**20.** Procédé selon la revendication 19, **caractérisé par le fait qu'**on réalise plusieurs boîtes quantiques adjacentes (BQ), et **par le fait que** réalisation comporte une croissance sélective de germanium sur la surface d'une première région prédéterminée du substrat, puis une croissance sélective de silicium sur le germanium.

**21.** Procédé selon la revendication 19 ou 20, **caractérisé par le fait que** la réalisation du transistor comporte la formation sur la surface d'une deuxième région prédéterminée du substrat d'un corps de grille (CRG) isolée de ladite surface par un oxyde de grille (OX), puis une gravure latérale du corps de grille de façon à former un pied de grille surmonté d'un chapeau.

**22.** Procédé selon la revendication 21, **caractérisé par le fait que** le corps de grille est un empilement hétérogène comprenant une couche inférieure (CH2) et une couche supérieure (CH1), le matériau de la couche supérieure pouvant être gravé sélectivement par rapport au matériau de la couche supérieure.

**23.** Procédé selon la revendication 22, **caractérisé par le fait que** le matériau de la couche inférieure (CH2) est un alliage de silicium et de germanium, tandis que matériau de la couche supérieure (CH1) est du silicium.

**24.** Procédé selon l'une des revendications 21 à 23, **caractérisé par le fait que** les régions de source et de drain sont implantées dans le substrat en utilisant le chapeau de grille comme masque dur.

**25.** Procédé d'émission d'un photon unique, comportant une application sur la grille en forme de champignon d'un transistor MOS, d'une tension de commande de façon à générer un unique électron au niveau du drain du transistor, et un piégeage de cet électron unique dans une boîte quantique provoquant l'émission d'un photon unique.

**Claims**

**1.** Integrated circuit, comprising a semiconductor device forming a single-photon source, comprising, on a silicon substrate (SB), an MOS transistor (TR) having a mushroom-shaped gate, capable of controllably delivering, to its drain, a single electron in response to a control voltage applied to its gate, and at least one silicon compatible quantum box (QB) electrically coupled to the drain region (D) of the transistor and capable of emitting a single photon upon receiving a single electron emitted by the transistor.

**2.** Integrated circuit according to Claim 1, **characterized in that** the gate (G) of the transistor includes a gate foot (GF) having a length L and a width W surmounted by a gate cap (GC), lateral isolating regions or spacers (SPA) on the sidewalls of the gate, and source and drain regions located in the substrate at a certain distance from the lateral edges of the gate foot.

**3.** Integrated circuit according to Claim 2, **characterized in that** the values of L and W are chosen so that the thermal energy of the electrons in the source of the transistor (TR) is lower than the electrostatic energy of an electron penetrating the channel of the transistor.

4. Integrated circuit according to Claim 3, **characterized in that** the operating temperature of the device is below 77 K and **in that** L is less than 50 nanometres.

5. Integrated circuit according to Claim 3 or 4, **characterized in that** W is less than a few hundred nanometres, for example 500 nanometres.

6. Integrated circuit according to one of the preceding claims, **characterized in that** the voltage applied to the drain (D) of the transistor is less than 10 mV.

7. Integrated circuit according to one of the preceding claims, **characterized in that** it includes control means (GCM) capable of delivering said control voltage, this control voltage having an at least zero first value in response to which the transistor is turned off and a second value for creating a quantum well in the channel of the transistor and for passing a single electron from the source into the channel and then into the drain.

8. Integrated circuit according to Claims 2 and 7, **characterized in that** L is equal to or greater than 10 nanometres, but less than 50 nanometres, and **in that** the product of the second control voltage value multiplied by the charge (e) of an electron is an integer multiple of the electrostatic energy of an electron penetrating the channel of the transistor.

9. Integrated circuit according to Claim 8, **characterized in that** the product of the second control voltage value multiplied by the charge (e) of an electron is equal to the electrostatic energy of an electron penetrating the channel of the transistor.

10. Integrated circuit according to Claims 2 and 7, **characterized in that** L is less than 10 nanometres and **in that** the second control voltage value corresponds to an alignment of the ground energy level of the device with the Fermi level of the source of the transistor.

11. Integrated circuit according to one of Claims 7 to 10, **characterized in that** the control means (GCM) are capable of delivering, in succession, the two control voltage values at a working frequency (f) above the output frequency of an electron from the channel.

12. Integrated circuit according to Claim 11, **characterized in that** the working frequency (f) is between 1 MHz and 1 GHz.

13. Integrated circuit according to one of the preceding claims, **characterized in that** the device includes several adjacent quantum boxes (QB).

14. Integrated circuit according to one of the preceding claims, **characterized in that** the substrate (SB) includes an additional implanted zone (IMZ), located beneath each quantum box, of the same type of conductivity as that of the drain region and in contact with the drain region.

15. Integrated circuit according to one of the preceding claims, **characterized in that** each quantum box (QB) comprises germanium encapsulated in silicon.

16. Integrated circuit according to one of the preceding claims, **characterized in that** the device includes a layer of insulating material (ENR) encapsulating the transistor, this layer of insulating material being an aperture opening above the quantum boxes and forming an optical waveguide (WG).

17. Integrated circuit according to one of the preceding claims, **characterized in that** it is placed in a refrigerated enclosure.

18. Cryptography device, **characterized in that** it includes an integrated circuit according to one of Claims 1 to 17.

19. Method for fabricating an integrated circuit, comprising a semiconductor device forming a single-photon source, in which an MOS transistor (TR) is produced in and on a silicon substrate (SB), having a mushroom-shaped gate, capable of controllably delivering, to its drain, a single electron in response to a control voltage applied to its gate, and at least one silicon compatible quantum box (QB) electrically coupled to the drain region of the transistor and capable of emitting a single photon upon receiving a single electron emitted by the transistor.

20. Method according to Claim 19, **characterized in that** several adjacent quantum boxes (QB) are produced and **in that** the production includes a selective growth of germanium on the surface of a first predetermined region of the substrate followed by a selective growth of silicon on the germanium.

21. Method according to Claim 19 or 20, **characterized in that** the production of the transistor includes the formation, on the surface of a second predetermined region of the substrate, of a gate body (GB) isolated from said surface by a gate oxide (OX) and then the lateral etching of the gate body so as to form a gate foot surmounted by a cap.

22. Method according to Claim 21, **characterized in that** the gate body is a heterogeneous multilayer comprising a lower layer (LAY2) and an upper layer (LAY1), it being possible for the lower layer to be etched selectively with respect to the material of the upper layer.

23. Method according to Claim 22, **characterized in that** the material of the lower layer (LAY2) is a silicon-germanium alloy, whereas the material of the upper layer (LAY1) is silicon.

24. Method according to one of Claims 21 to 23, **characterized in that** the source and drain regions are implanted in the substrate using the gate cap as hard mask.

25. Single-photon emission method, which includes the application of a control voltage to the mushroom-shaped gate of an MOS transistor so as to generate a single electron in the drain of the transistor and the trapping of this single electron in a quantum box, forcing the emission of a single photon.

**Patentansprüche**

1. Integrierte Schaltung, die eine Halbleitervorrichtung enthält, die eine Einzelphotonenquelle bildet und auf einem Siliziumsubstrat (SB) einen MOS-Transistor (TR) mit einem pilzförmigen Gate, der in Reaktion auf eine an sein Gate angelegte Steuerspannung an seinem Drain auf kontrollierte Weise ein einzelnes Elektron abgeben kann, und wenigstens einen mit Silizium kompatiblen Quantenkasten (BQ), der mit dem Drain-Bereich (D) des Transistors elektrisch gekoppelt ist und bei Empfang eines von dem Transistor ausgesendeten einzelnen Elektrons ein einzelnes Photon aussenden kann, enthält.

2. Integrierte Schaltung nach Anspruch 1, **dadurch gekennzeichnet, dass** das Gate (G) des Transistors einen Gate-Fuß (GP) mit einer Länge L und einer Breite W, auf dem ein Hut (GCH) angebracht ist, seitliche isolierende Bereiche (ESP) an den Seiten des Gates sowie Source- und Drain-Bereiche, die sich im Substrat in einem Abstand von den Seitenrändern des Gate-Fußes befinden, aufweist.

3. Integrierte Schaltung nach Anspruch 2, **dadurch gekennzeichnet, dass** die Werte von L und W in der Weise gewählt sind, dass die thermische Energie der Elektronen in der Source des Transistors (TR) niedriger ist als die elektrostatische Energie eines in den Kanal des Transistors eindringenden Elektrons.

4. Integrierte Schaltung nach Anspruch 3, **dadurch gekennzeichnet, dass** die Betriebstemperatur der Vorrichtung unter 77°K liegt und dass L kleiner als 50 Nanometer ist.

5. Integrierte Schaltung nach Anspruch 3 oder 4, **dadurch gekennzeichnet, dass** W kleiner als einige hundert Nanometer, beispielsweise 500 Nanometer ist.

6. Integrierte Schaltung nach einem der vorhergehenden Ansprüche, **dadurch gekennzeichnet, dass** die an den Drain (D) des Transistors angelegte Spannung kleiner als 10 mV ist.

7. Integrierte Schaltung nach einem der vorhergehenden Ansprüche, **dadurch gekennzeichnet, dass** sie Steuermittel (MCG) aufweist, die die Steuerspannung liefern können, wobei diese Steuerspannung einen ersten Wert hat, der wenigstens null ist und in Reaktion auf den der Transistor sperrt, und einen zweiten Wert hat, der die Erzeugung eines Quantentopfs in dem Kanal des Transistors und das Durchlassen eines einzelnen Elektrons von der Source in den Kanal und dann zum Drain ermöglicht.

8. Integrierte Schaltung nach den Ansprüchen 2 und 7, **dadurch gekennzeichnet, dass** L größer oder gleich 10 Nanometer und kleiner als 50 Nanometer ist und dass das Produkt aus dem zweiten Wert der Steuerspannung und der Ladung (e) eines Elektrons ein ganzzahliges Vielfaches der elektrostatischen Energie eines in den Kanal des Transistors eindringenden Elektrons ist.

9. Integrierte Schaltung nach Anspruch 8, **dadurch gekennzeichnet, dass** das Produkt aus dem zweiten Wert der Steuerspannung und der Ladung (e) eines Elektrons gleich der elektrostatischen Energie eines in den Kanal des Transistors eindringenden Elektrons ist.

10. Integrierte Schaltung nach den Ansprüchen 2 und 7, **dadurch gekennzeichnet, dass** L kleiner als 10 Nanometer ist und dass der zweite Wert der Steuerspannung einer Ausrichtung des Grundniveaus der Energie der Vorrichtung auf das Fermi-Niveau der Source des Transistors entspricht.

11. Integrierte Schaltung nach einem der Ansprüche 7 bis 10, **dadurch gekennzeichnet, dass** die Steuermittel (MCG) die beiden Werte der Steuerspannung nacheinander mit einer Arbeitsfrequenz (f), die höher als die Ausgangsfrequenz eines Elektrons des Kanals ist, liefern können.

12. Integrierte Schaltung nach Anspruch 11, **dadurch gekennzeichnet, dass** die Arbeitsfrequenz (f) im Bereich von 1 MHz bis 1 GHz liegt.

13. Integrierte Schaltung nach einem der vorhergehenden Ansprüche, **dadurch gekennzeichnet, dass** die Vorrichtung mehrere benachbarte Quantentöpfe (BQ) enthält.

14. Integrierte Schaltung nach einem der vorhergehenden Ansprüche, **dadurch gekennzeichnet, dass** das Substrat (SB) einen zusätzlichen implantierten Bereich (ZIM) aufweist, der sich unter jedem Quantenkasten befindet und vom gleichen Leitfähigkeitstyp wie jener des Drain-Bereichs ist und mit dem Drain-Bereich in Kontakt ist.

15. Integrierte Schaltung nach einem der vorhergehenden Ansprüche, **dadurch gekennzeichnet, dass** jeder Quantenkasten (BQ) in Silizium eingekapseltes Germanium enthält.

16. Integrierte Schaltung nach einem der vorhergehenden Ansprüche, **dadurch gekennzeichnet, dass** die Vorrichtung eine den Transistor umhüllende isolierende Materialschicht (ENR) aufweist, wobei diese isolierende Materialschicht eine Öffnung besitzt, die in die Umgebung über den Quantentöpfen mündet und einen Lichtwellenleiter (GUD) bildet.

17. Integrierte Schaltung nach einem der vorhergehenden Ansprüche, **dadurch gekennzeichnet, dass** sie in ein gekühltes Gehäuse eingesetzt ist.

18. Kryptographievorrichtung, **dadurch gekennzeichnet, dass** sie eine integrierte Schaltung nach einem der Ansprüche 1 bis 17 enthält.

19. Verfahren für die Fertigung einer integrierten Schaltung mit einer Halbleitervorrichtung, die eine Einzelphotonenquelle bildet, bei dem in und auf einem Siliziumsubstrat (SR) ein MOS-Transistor (TR) mit einem pilzförmigen Gate, der in Reaktion auf eine an sein Gate angelegte Steuerspannung an seinem Drain auf kontrollierte Weise ein einzelnes Elektron liefern kann, und wenigstens ein mit Silizium kompatibler Quantenkasten (BQ), der mit dem Drain-Bereich des Transistors elektrisch gekoppelt ist und bei Empfang eines von dem Transistor ausgesendeten einzelnen Elektrons ein einzelnes Photon aussenden kann, verwirklicht werden.

20. Verfahren nach Anspruch 19, **dadurch gekennzeichnet, dass** mehrere aneinander grenzende Quantentöpfe (BQ) verwirklicht werden und dass die Verwirklichung ein selektives Wachstum von Germanium auf der Oberfläche eines vorgegebenen ersten Bereichs des Substrats und dann ein selektives Wachstum von Silizium auf dem Germanium enthält.

21. Verfahren nach Anspruch 19 oder 20, **dadurch gekennzeichnet, dass** die Verwirklichung des Transistors die Bildung eines Gate-Körpers (CRG) auf der Oberfläche eines zweiten vorgegebenen Bereichs des Substrats, der von der Oberfläche durch ein Gate-Oxid (OX) isoliert ist, und dann ein seitliches Ätzen des Gate-Körpers in der Weise, dass ein Gate-Fuß gebildet wird, auf dem ein Hut angebracht ist, enthält.

22. Verfahren nach Anspruch 21, **dadurch gekennzeichnet, dass** der. Gate-Körper ein heterogener Stapel ist, der eine untere Schicht (CH2) und eine obere Schicht (CH1) aufweist, wobei das Material der unteren Schicht in Bezug auf das Material der oberen Schicht selektiv geätzt werden kann.

23. Verfahren nach Anspruch 22, **dadurch gekennzeichnet, dass** das Material der unteren Schicht (CH2) eine Legierung aus Silizium und Germanium ist, während das Material der oberen Schicht (CH1) Silizium ist.

24. Verfahren nach einem der Ansprüche 21 bis 23, **dadurch gekennzeichnet, dass** die Source- und Drain-Bereiche in das Substrat unter Verwendung des Gate-Huts als harte Maske implantiert werden.

25. Verfahren zum Aussenden eines einzelnen Photons, das das Anlegen einer Steuerspannung an das Gate in Form eines Pilzes eines MOS-Transistors, derart, dass auf dem Niveau des Drains des Transistors ein einzelnes Elektron erzeugt wird, und ein Einfangen dieses einzelnen Elektrons in einem Quantenkasten, was die Aussendung eines einzelnen Photons hervorruft, enthält.

# FIG.1

## FIG.2

ENR    CS  G  CG  GCH  TR  CD    GUD    BQ    DSP

STI    S  ESP  OX  GP  ESP    D    ZIM    STI

SB

## FIG.3

L

GP

W    Source    Drain

Ec

X

ZNO

PQ

## FIG.4a

EF ------ eVd

## FIG.4b

EF ------ eVd

## FIG.4c

PQ

EF ------ eVd

## FIG.4d

1e⁻    PQ

EF ------ eVd

## FIG.4e

2ème e⁻    PQ

EF ------ eVd

## FIG.4f

PQ    1e⁻

EF ------ eVd

EP 1 363 372 B1

FIG.5a

FIG.5b

FIG.5c

FIG.5d

FIG.5e

EF

eVd

PQ

N1

1e⁻

2ème e⁻

# FIG.6

EP 1 363 372 B1

## FIG.7a

STI          OX        STI

SB

## FIG.7b

STI     MSD     OX     STI

ZIM

SB

## FIG.7c

STI     MSD     OX     STI

BQ

ZIM

SB

# FIG.7d

STI  OX  BQ  STI

ZIM

SB

# FIG.7e

CRG

CH1  OX  BQ  STI
CH2

STI

ZIM

SB

# FIG.7f

G

STI  LDD1  GCH  OX  LDD2  BQ  STI
GP
GRL → ← GRL

ZIM

SB

## FIG.7g

STI     S   ESP    G    ESP   D    OX      BQ      STI

ZIM

SB

## FIG.7h

STI    ENR          TR         BQ    STI

SB

## FIG.7i

ENR        TR   MTL       BQ

SB